# EUROPÄISCHE PATENTSCHRIFT

(11) **EP 3 914 883 B1**
(45) Veröffentlichungstag und Bekanntmachung des Hinweises auf die Patenterteilung: **27.08.2025**
(21) Anmeldenummer: 20700965.5
(22) Anmeldetag: 08.01.2020
(51) Int. Cl.: G01J 1/02, G01S 3/784, B32B 17/10, G01J 1/42, G01J 1/16, G01J 1/04, H10F 77/00

(54) **FAHRZEUG-SCHEIBE MIT EINEM RICHTUNGSABHÄNGIGEN LICHTSENSOR**
PLATE WITH A DIRECTIONAL LIGHT SENSOR
VITRE DOTÉE D'UN CAPTEUR DE LUMIÈRE DÉPENDANT DE LA DIRECTION

(30) Priorität: 22.01.2019 EP 19153012
(43) Veröffentlichungstag der Anmeldung: 01.12.2021
(73) Patentinhaber: Saint-Gobain Sekurit France, 60150 Thourotte (FR)
(72) Erfinder: MATHEISEN, Christopher, 52134 Herzogenrath (DE); VARGA, Gabor, 52134 Herzogenrath (DE); STELZER, Richard, 52066 Aachen (DE); KAPLAN, Benjamin, 69514 Laudenbach (DE)
(74) Vertreter: Gebauer, Dieter Edmund
(86) Internationale Anmeldenummer: PCT/EP2020/050239
(87) Internationale Veröffentlichungsnummer: WO 2020/151942

(56) Entgegenhaltungen:
- WO-A1-2017/097536
- WO-A1-2017/178146
- US-B1- 6 521 882
- US-B2- 9 041 135

## Beschreibung

Die Erfindung betrifft eine Fahrzeug-Scheibe mit einem richtungsabhängigen Lichtsensor.

Es ist bekannt, Fahrzeuge mit hochauflösenden Kameras auszustatten. Diese hochauflösenden Kameras werden für unterschiedlichste Zwecke verwendet. Jedoch sind sie zur Bereitstellung ihrer Funktion auf zusätzliche Information, z.B. eine Umgebungslichterkennung, angewiesen. Die zusätzliche Information wird z.B. zur Steuerung von Aufnahmeparametern, wie z.B. der der Blende, verwendet, um das Kamerasystem den wechselnden Bedingungen anzupassen, sodass ein aussagekräftiges Bild dem Benutzer zur Verfügung gestellt werden kann.

Diese Kameras sind aufgrund der notwendigen Optik so voluminös, dass sie nicht in eine Fahrzeugscheibe integriert werden können.

Es ist weiterhin bekannt, z.B. Fahrzeugscheiben mit Lichtsensoren auszustatten. Solche Sensoren werden z.B. zur Erkennung des Umgebungslichts und/oder als Detektor für Tropfen auf einer Fahrzeugscheibe (Regendetektor) verwendet.

Typische Sensoren sind intensitätsbasiert, wobei Licht unmittelbar oder mittelbar über ein Linsen- und Spiegelsystem auf einen Fotowiderstand / Fototransistor / Fotodiode / lichtempfindliches Element gelenkt wird.

Allerdings sind diese Sensoren nicht geeignet, Umgebungslicht von Licht anderer Quellen, wie z.B. Sonneneinstrahlung / Scheinwerfern (z.B. eines entgegenkommenden Fahrzeugs) bzw. deren jeweiligen Reflexionen zu unterscheiden.

D.h., außer der Information Licht / kein Licht und eventuell einer Intensität kann keine weitere Information gewonnen werden.

Aus dem US-Patent 9,041,135 B2 ist eine monolithische Sonnensensoranordnung für Luftfahrzeuge bekannt, bei der lichtempfindliche Elemente auf einem Halbleiter-Substrat bereitgestellt werden.

Monolithische Sensoren sind nicht nur wegen ihrer Größe, sondern auch wegen Problemen mit der Anbindung an elektronische Komponenten nicht zur Integration in eine Fahrzeug-Scheibe geeignet.

Aus dem US-Patent 6,521,882 B1 ist ein weiterer optischer Sensor bekannt. Dieser ist ebenfalls ein eigenständiger Sensor mit einer Linsenanordnung. Der Sensor ermöglicht es jedoch nur einen Elevationswinkel zu bestimmen. Eine Richtungsbestimmung wird hierdurch nicht ermöglicht. Ebenso ist der Sensor nicht nur wegen seiner Größe, sondern auch wegen Problemen mit der Anbindung an elektronische Komponenten nicht zur Integration in eine Fahrzeug-Scheibe geeignet.

Zugleich besteht aber ein Bedarf nach Richtungsinformation. Zusätzlich besteht der Wunsch danach Funktionen platzsparend in eine Fahrzeug-Scheibe zu integrieren.

Aus der internationalen Patentanmeldung WO/2017/097536 ist eine Fahrzeug-Verbundscheibe mit integriertem Lichtsensor bekannt. Der Lichtsensor befindet sich in der Zwischenschicht der Verbundscheibe.

Ausgehend von dieser Situation ist es eine Aufgabe der Erfindung, eine Fahrzeug-Scheibe mit einem richtungsabhängigen Lichtsensor zur Verfügung zu stellen.

Die Aufgabe wird gelöst durch eine Fahrzeug-Scheibe mit einem richtungsabhängigen Lichtsensor, aufweisend eine erste Glasschicht und eine zweite Glasschicht, wobei zwischen der ersten Glasschicht und der zweiten Glasschicht eine Anordnung von lichtempfindlichen Elementen im Wesentlichen parallel zur ersten Glasschicht angeordnet ist, wobei die Fahrzeug-Scheibe weiterhin eine Blende aufweist, sodass Licht durch die zweite Glasschicht und die Blende hindurch auf zumindest eines der lichtempfindlichen Elemente einstrahlen kann, wobei abhängig von der Richtung von einfallendem Licht der Sensor ein Signal bereitstellt, das indikativ für die Richtung ist. Die Anordnung von lichtempfindlichen Elementen weist einen Kamerachip auf. Gemäß der Erfindung ist die Anordnung von lichtempfindlichen Elementen auf einer flexiblen Folie angeordnet.

D.h. die Erfindung stellt auf einfache Weise einen richtungsabhängigen Lichtsensor zur Verfügung mit Hilfe dessen die Richtung eines einfallenden Lichts erkannt und damit unterschieden werden kann, ob es sich um Sonnenlicht oder Licht eines entgegenkommenden Fahrzeugs handelt. Zudem kann die Erfindung auf bewährte Bauteilkonzepte aufbauen, sodass die Entwicklungskosten und/oder Herstellungskosten geringgehalten werden können. Mit einer solchen Anordnung können z.B. gebogene Fahrzeugscheiben mit der Erfindung ausgestattet werden.

Ein Zwischenraum ist von der Blende, der Anordnung der lichtempfindlichen Elemente und der Umgebungsschicht begrenzt, wobei der Zwischenraum zwischen der Blende, der Anordnung von lichtempfindlichen Elementen und der Umgebungsschicht angeordnet ist, wobei der Zwischenraum ein Hohlraum ist.

In einer weiteren Ausführungsform der Erfindung weist die Anordnung von lichtempfindlichen Elementen eine array-artige Anordnung von zumindest vier lichtempfindlichen Elementen auf.

D.h. mittels einer Quadrantenerkennung kann in besonders einfacher Weise eine Richtungserkennung durchgeführt werden.

In noch einer weiteren Ausführungsform der Erfindung ist zwischen der ersten Glasschicht und der zweiten Glasschicht ein Verbundmaterial ausgewählt aus der Gruppe aufweisend Polyimid, Polyurethan, Polymethylenmethacrylsäure, Polykarbonat, Polyethylenterephthalat, Polyvinylbutyral, FR6, Acryllnitril-Butadien-Styrol-Copolymerisat, Polyethylen, Polypropylen, Polyvinylchlorid, Polystyrol, Polybutylenterephthalat, Polyamid angeordnet.

Damit kann die Erfindung auch ohne Weiteres in Verbundscheibensystemen eingepasst werden.

Als Glasschicht sind im Grunde alle elektrisch isolierenden Substrate geeignet, die unter den Bedingungen der Herstellung und der Verwendung der erfindungsgemäßen Fahrzeug-Scheibe thermisch und chemisch stabil sind.

Die Glasschicht enthält bevorzugt Glas, besonders bevorzugt Flachglas, Floatglas, Quarzglas, Borosilikatglas, Kalk-Natron-Glas oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon.

Gemäß noch einer weiteren Ausführungsform der Erfindung weist die Folie eine Dicke von 50 µm bis 500 µm auf.

In einer weiteren Ausführungsform der Erfindung ist die Blende als eine Lochblende ausgestaltet. Lochblenden sind besonders einfach herstellbar und in Bezug auf ihre optischen Eigenschaften gut zu beherrschen.

In noch einer weiteren Ausführungsform der Erfindung ist die Blende zwischen der Anordnung von lichtempfindlichen Elementen und der zweiten Glasschicht in einem vorbestimmten Abstand angeordnet.

D.h. durch Bereitstellung eines vorkonfigurierten Systems können Entwicklungs- als auch Herstellungskosten geringgehalten werden.

Ohne Beschränkung der Allgemeinheit erlaubt die Erfindung auch die Bereitstellung von Fahrzeugen mit einer Fahrzeug-Scheibe gemäß der Erfindung. Das Fahrzeug kann dabei insbesondere ein Land-, ein See-, ein Luft- oder ein Raumfahrzeug sein, ohne Mischformen hiervon auszuschließen.

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Fig. 1: einen schematischen Querschnitt in Bezug auf eine Anordnung von Schichten gemäß Aspekten der Erfindung,
- Fig. 2: einen schematischen Querschnitt in Bezug auf eine Anordnung von Schichten gemäß Aspekten der Erfindung und einem beispielhaften Lichteinfall,

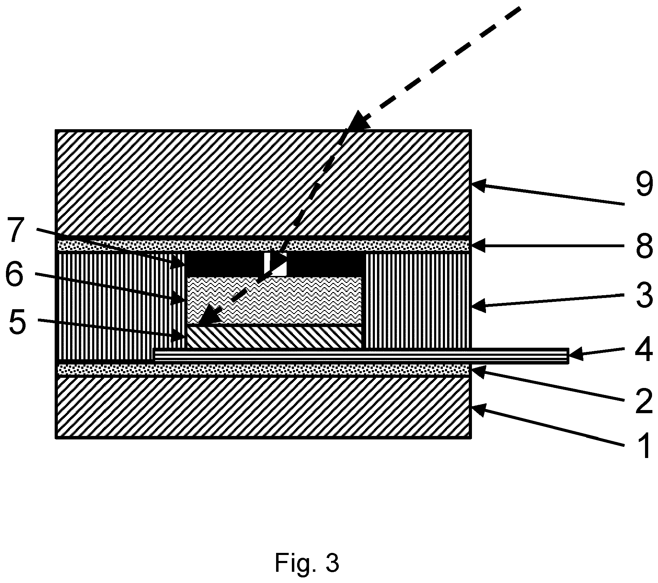

- Fig. 3: einen schematischen Querschnitt in Bezug auf eine Anordnung von Schichten und einen beispielhaften Lichteinfall, welche in den Patentansprüchen nicht beansprucht ist, und
- Fig. 4: eine schematische Aufsicht auf einer Anordnung von lichtempfindlichen Elementen in Ausführungsformen der Erfindung.

Nachfolgend wird die Erfindung eingehender unter Bezugnahme auf die Figuren dargestellt werden. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden soweit nicht explizit als reine Alternative dargestellt.

Weiterhin wird nachfolgend der Einfachheit halber in aller Regel immer nur auf eine Entität Bezug genommen. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

Soweit nachfolgend Verfahren beschrieben werden, sind die einzelnen Schritte eines Verfahrens in beliebiger Reihenfolge anordbar und/oder kombinierbar, soweit sich durch den Zusammenhang nicht explizit etwas Abweichendes ergibt. Weiterhin sind die Verfahren - soweit nicht ausdrücklich anderweitig gekennzeichnet - untereinander kombinierbar.

Angaben mit Zahlenwerten sind in aller Regel nicht als exakte Werte zu verstehen, sondern beinhalten auch eine Toleranz von +/- 1 % bis zu +/- 10 %.

Soweit in dieser Anmeldung Normen, Spezifikationen oder dergleichen benannt werden, werden zumindest immer die am Anmeldetag anwendbaren Normen, Spezifikationen oder dergleichen in Bezug genommen. D.h. wird eine Norm / Spezifikation etc. aktualisiert oder durch einen Nachfolger ersetzt, so ist die Erfindung auch hierauf anwendbar.

In den Figuren sind verschieden Ausführungsformen dargestellt.

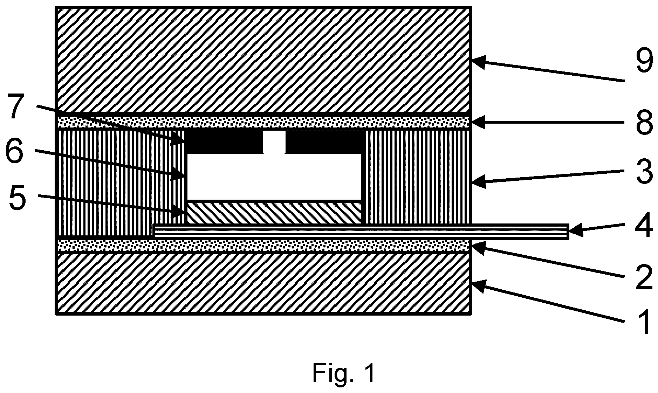

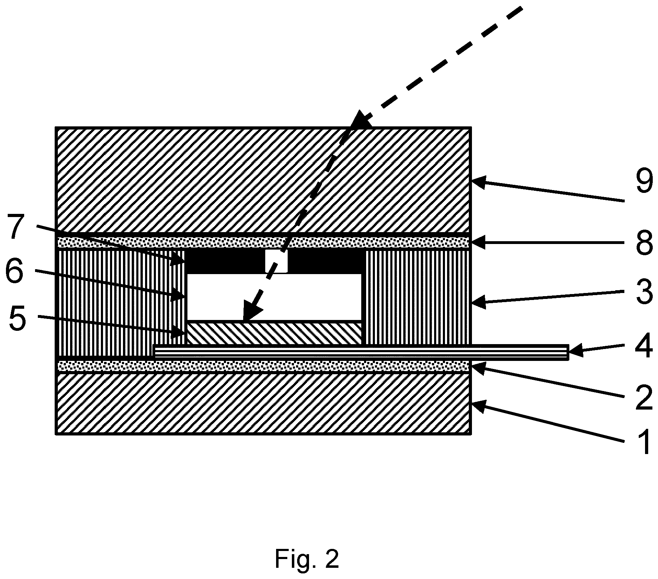

In Figuren 1 und 2 ist eine Fahrzeug-Scheibe mit einem richtungsabhängigen Lichtsensor gemäß Ausführungsformen der Erfindung schematisch dargestellt.

Die Fahrzeug-Scheibe weist eine erste Glasschicht 1 und eine zweite Glasschicht 9 auf. Die Glasschichten 1 und 9 können sowohl flach als auch gebogen sein. Im Folgenden werden wir davon ausgehen, dass der zu untersuchende Lichteinfall durch die zweite Glasschicht 9 erfolgt.

Zwischen der ersten Glasschicht 1 und der zweiten Glasschicht 9 ist eine Anordnung von lichtempfindlichen Elementen 5 im Wesentlichen parallel zur ersten Glasschicht 1 angeordnet. Ohne Beschränkung der Allgemeinheit kann die Anordnung von lichtempfindlichen Elementen 5 auch alternativ oder zusätzlich im Wesentlichen parallel zur zweiten Glasschicht 9 angeordnet sein.

Weiterhin weist die Fahrzeug-Scheibe eine Blende auf, sodass Licht durch die zweite Glasschicht 9 und die Blende 7 hindurch auf zumindest eines der lichtempfindlichen Elemente 5 einstrahlen kann, wobei abhängig von der Richtung von einfallendem Licht der Sensor ein Signal bereitstellt, das indikativ für die Richtung ist.

Dabei macht sich die Erfindung - wie nun in Bezug auf Figur 2 erläutert werden wird - zu eigen, dass durch die Blende 7 Licht aus unterschiedlichen Raumwinkeln vor der Blende auch auf unterschiedliche Raumwinkel nach der Blende abbildet. Somit steht eine kostengünstige Lochkamera zur Verfügung, die ohne weitere Optik eine zuverlässige und kostengünstige Richtungsdetektion zulässt.

Mittels einer geeigneten Auswerteschaltung, z.B. mittels Messbrücken, Komparatoren etc. kann dann anhand elektrischer Signale entschieden werden, aus welcher (groben) Raumrichtung Licht eingetreten ist. Die Auswerteschaltung kann dabei ebenfalls in die Fahrzeug-Scheibe integriert sein oder aber extern hierzu bereitgestellt werden.

D.h. die Erfindung stellt auf einfache Weise einen richtungsabhängigen Lichtsensor zur Verfügung mit Hilfe dessen die Richtung eines einfallenden Lichts erkannt und damit unterschieden werden kann, ob es sich um Sonnenlicht oder Licht eines entgegenkommenden Fahrzeugs handelt.

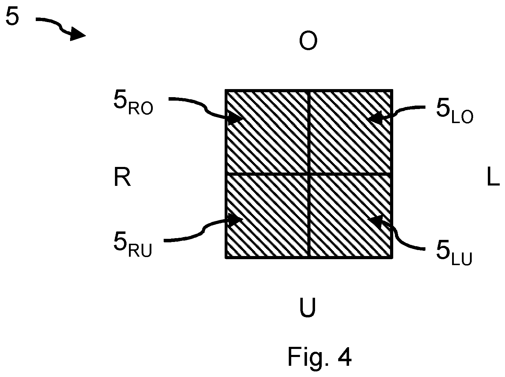

In einer sehr einfachen Anordnung weist die Anordnung von lichtempfindlichen Elementen 5 - wie in Figur 4 gezeigt - eine array-artige Anordnung von zumindest 4 lichtempfindlichen Elementen auf.

Mitthilfe dieser Anordnung ist es möglich, Licht in verschiedene Richtungen zu unterscheiden. Trifft Licht nur auf ein bestimmtes lichtempfindliches Element, so kann diesem lichtempfindlichen Element ein bestimmter Raumwinkel zugeordnet werden.

Trifft beispielsweise Licht auf das rechte untere Element 5_{RU}, so kann hieraus ein erster bestimmter Raumwinkelbereich abgeleitet werden. Trifft beispielsweise Licht auf das rechte obere Element 5_{RO}, so kann hieraus ein zweiter bestimmter Raumwinkelbereich abgeleitet werden

Trifft hingegen Licht sowohl auf das rechte untere Element 5_{RU} als auch auf das rechte obere Element 5_{RO}, so kann daraus gefolgert werden, dass der Ursprung des Lichtes aus dem Überlappungsbereich / Grenzbereich des ersten bestimmten Raumwinkelbereiches und des zweiten bestimmten Raumwinkelbereich stammt.

D.h., mittels einfacher Auswertelogik kann bereits eine Quadrantenerkennung und damit eine Richtungserkennung in besonders einfacher Weise durchgeführt werden.

Erfindungsgemäß weist die Anordnung von lichtempfindlichen Elementen 5 einen Kamerachip auf.

Dabei kann vorgesehen sein, dass alle oder nur eine Teilmenge der zur Verfügung stehenden Pixel ausgewertet werden. Weiterhin kann vorgesehen sein, dass benachbarte Pixel als Pixelgruppe gemeinsam ausgewertet werden, um eine schnelle Verarbeitung zu gewährleisten. Allerdings geht damit einher auch ein Verlust an Raumwinkelauflösung.

Kamerachips bieten zudem die Möglichkeit, Farbkanäle einzeln auszuwerten. Daher wäre es möglich, z.B. aus unterschiedlichen Farbintensitäten betreffend einen Winkelbereich weitere Informationen über die Lichtquelle, wie z.B. Kunstlicht (Scheinwerferlicht) oder Sonnenlicht zu erhalten. Bei geeigneter Dimensionierung und Ausrichtung können sogar Verkehrssignale, wie z.B. Ampeln, Warnleuchten, etc. erkannt werden. Die Anordnung erlaubt dabei unterschiedliche Lichtquellen auch zur selben Zeit an Hand unterschiedlicher Richtungen (und Farbzusammensetzung) zu erkennen. Zudem kann bei entsprechender Auflösung durch die lichtempfindlichen Elemente 5 auch eine Erkennung von räumlichen Strukturen, wie z.B. Tunnel, Brücken, Straßenlampen, Ampeln bereitgestellt werden.

D.h., die Erfindung kann auf bewährte Bauteilkonzepte aufbauen, sodass die Entwicklungskosten und/oder Herstellungskosten geringgehalten werden können.

In der Ausführungsform, die in Figur 2 dargestellt ist, ist der Zwischenraum 6 zwischen der Blende 7 und der Anordnung von lichtempfindlichen Elementen 5 ein Hohlraum.

In einer Ausführungsform der Erfindung weist die Fahrzeug-Scheibe nach zwischen der ersten Glasschicht 1 und der zweiten Glasschicht 9 eine Umgebungsschicht 3 auf. Die Umgebungsschicht 3 weist ein Verbundmaterial ausgewählt aus der Gruppe aufweisend Polyimid, Polyurethan, Polymethylenmethacrylsäure, Polykarbonat, Polyethylenterephthalat, Polyvinylbutyral, FR6, Acryllnitril-Butadien-Styrol-Copolymerisat, Polyethylen, Polypropylen, Polyvinylchlorid, Polystyrol, Polybutylenterephthalat, Polyamid auf.

Damit kann die Erfindung auch ohne Weiteres in Verbundscheibensystemen eingepasst werden.

Gemäß der Erfindung ist die Anordnung von lichtempfindlichen Elementen 5 auf einer flexiblen Folie 4, z.B. einer flexiblen Leiterplatte angeordnet.

Mit einer solchen Anordnung können z.B. gebogene Fahrzeug-Scheiben mit der Erfindung ausgestattet werden.

In einer weiteren Ausführungsform der Erfindung weist die Folie 4 eine Dicke von 50 µm bis 500 µm, insbesondere circa 300 µm auf.

In einer weiteren Ausführungsform der Erfindung ist die Blende als eine Lochblende ausgestaltet. Lochblenden sind besonders einfach herstellbar und in Bezug auf ihre optischen Eigenschaften gut zu beherrschen.

In noch einer weiteren Ausführungsform der Erfindung ist die Blende 4 zwischen der Anordnung von lichtempfindlichen Elementen 5 und der zweiten Glasschicht 9 in einem vorbestimmten Abstand angeordnet.

Die Blende 4 kann z.B. eine Materialstärke von circa 0,5 mm und weniger, insbesondere 0,025 mm und weniger aufweisen.

Ohne Beschränkung der Allgemeinheit kann der Abstand zwischen Blende 7 und der Anordnung lichtempfindlicher Elemente 5 0,8 mm und weniger, insbesondere 0,6 mm und weniger betragen.

D.h. durch Bereitstellung eines vorkonfigurierten Systems können Entwicklungs- als auch Herstellungskosten geringgehalten werden.

Ohne Beschränkung der Allgemeinheit erlaubt die Erfindung auch die Bereitstellung von Fahrzeugen mit einer Fahrzeug-Scheibe gemäß der Erfindung. Das Fahrzeug kann dabei insbesondere ein Land-, ein See-, ein Luft- oder ein Raumfahrzeug sein, ohne Mischformen hiervon auszuschließen.

In den Figuren sind weitere optionale Verbindungsschichten 8 bzw. 2 dargestellt. Die optionale Verbindungsschicht 2 kann alleine, alternativ zu oder in Kombination mit einer optionalen Verbindungsschicht 8 vorhanden sein. Diese optionalen Verbindungsschichten 8 bzw. 2 können ebenfalls aus dem gleichen / gleichartigen Material wie die Umgebungsschicht, d.h. aus einem Verbundmaterial hergestellt sein. Typischerweise weisen diese optionalen Verbindungsschichten 8 bzw. 2 eine Dicke von 0,01 mm auf. Mittels der Verbindungsschichten kann z.B. im Zusammenspiel mit der Dicke der Glasschicht 9 der Winkelbereich bei einem vorgegeben Abstand der Blende 7 zur Anordnung lichtempfindlicher Elemente 5 eingestellt werden.

D.h., die Erfindung erlaubt das Einlaminieren einer optischen Sensormatrix 5. Diese kann als Kamerachip ausgeführt sein. Durch die Bereitstellung einer Blende 7 wird eine einfache optische Abbildung ähnlich einer Lochkamera bereitgestellt.

Dabei reichen die optischen Eigenschaften aus um Raumwinkelbereich separierbar abzubilden, sodass effektiv eine Erkennung des Raumwinkelbereiches der Lichtquelle durchgeführt werden kann.

Dabei kann der Richtungssensor in die Fahrzeug-Scheibe selbst eingebracht werden.

Mittels eines solchen Richtungssensors kann z.B. in Abhängigkeit von der Sonneneinstrahlrichtung die Helligkeit eines Head-Up Displays geregelt werden, welches auf der Fahrzeug-Scheibe selbst zur Verfügung gestellt sein kann. Weiterhin kann die Richtungsinformation (als auch die Intensitätsinformation) für andere Zwecke, wie z.B. eine Lichtsteuerung, zur Verfügung gestellt werden.

Durch Wahl des Abstands der Blende 7 zu der Anordnung lichtempfindlicher Elemente 5 als auch durch die Wahl der Dicke einer eventuellen Zwischenschicht 8 kann der zur Analyse zur Verfügung stehende Raumwinkelbereich geeignet gewählt sein. Mittels der Größe der Öffnung der Blende 7, z.B. 0,5 mm oder weniger, insbesondere 0,1 mm oder weniger, kann zwischen notwendiger Lichtintensität und Auflösung in Bezug auf den zur Verfügung stehenden Abstand zwischen Blende 7 und der Anordnung lichtempfindlicher Elemente 5 (und deren Größe) eine geeignete Auflösung gewählt werden.

Es sei angemerkt, dass die Anordnung lichtempfindlicher Elemente 5 auch unter einem eventuellen Schwarzdruck angeordnet sein kann, soweit sichergestellt ist, dass in die Blende 7 aus einem geeignetem Raumwinkelbereich Licht eintreten kann. Dies kann z.B. durch eine vergleichsweise kleine Aussparung bereitgestellt werden.

Ohne Weiteres kann die Anordnung lichtempfindlicher Elemente 5, Blende 7 und Folie 4 als vorkonfektionierte Baueinheit zur Einlage in eine Verbundglasscheibe vorkonfektioniert sein.

### Bezugszeichenliste

- 1: erste Glasschicht
- 2: Verbindungsschicht (optional)
- 3: Umgebungsschicht
- 4: flexible Folie
- 5: Anordnung von lichtempfindlichen Elementen
- 6: Zwischenschicht (optional)
- 7: Blende
- 8: Verbindungsschicht (optional)
- 9: zweite Glasschicht

## Patentansprüche

1. Fahrzeug-Scheibe mit einem richtungsabhängigen Lichtsensor, aufweisend eine erste Glasschicht (1) und eine zweite Glasschicht (9), die durch eine Umgebungsschicht (3) miteinander verbunden sind, wobei zwischen der ersten Glasschicht (1) und der zweiten Glasschicht (9) eine Anordnung von lichtempfindlichen Elementen (5) im Wesentlichen parallel zur ersten Glasschicht (1) angeordnet ist, wobei die Scheibe weiterhin eine Blende (7) aufweist, sodass Licht durch die zweite Glasschicht (9) und die Blende (7) hindurch auf zumindest eines der lichtempfindlichen Elemente (5) einstrahlen kann, wobei abhängig von der Richtung von einfallendem Licht der Sensor ein Signal bereitstellt, das indikativ für die Richtung ist, wobei die Anordnung von lichtempfindlichen Elementen (5) einen Kamerachip aufweist und wobei die Anordnung von lichtempfindlichen Elementen (5) auf einer flexiblen Folie (4) angeordnet ist,
wobei ein Zwischenraum (6) von der Blende (7), der Anordnung der lichtempfindlichen Elemente (5) und der Umgebungsschicht (3) begrenzt ist,
wobei der Zwischenraum (6) zwischen der Blende (7) und der Anordnung von lichtempfindlichen Elementen (5) und der Umgebungsschicht (3) angeordnet ist, wobei der Zwischenraum (6) ein Hohlraum ist.

2. Fahrzeug-Scheibe nach Anspruch 1, **dadurch gekennzeichnet, dass** die Anordnung von lichtempfindlichen Elementen (5) eine array-artige Anordnung von zumindest vier lichtempfindlichen Elementen aufweist.

3. Fahrzeug-Scheibe nach einem der vorhergehenden Ansprüche, **dadurch gekennzeichnet, dass** zwischen der ersten Glasschicht (1) und der zweiten Glasschicht (9) ein Verbundmaterial ausgewählt aus der Gruppe, aufweisend Polyimid, Polyurethan, Polymethylenmethacrylsäure, Polycarbonat, Polyethylenterephthalat, Polyvinylbutyral, FR6, Acrylnitril-Butadien-Styrol-Copolymerisat, Polyethylen, Polypropylen, Polyvinylchlorid, Polystyrol, Polybutylenterephthalat und Polyamid, angeordnet ist.

4. Fahrzeug-Scheibe nach Anspruch 3, **dadurch gekennzeichnet, dass** die Folie eine Dicke von 50 µm bis 500 µm aufweist.

5. Fahrzeug-Scheibe nach einem der vorhergehenden Ansprüche, **dadurch gekennzeichnet, dass** die Blende (7) eine Lochblende ist.

6. Fahrzeug-Scheibe nach einem der vorhergehenden Ansprüche, **dadurch gekennzeichnet, dass** die Blende (7) zwischen der Anordnung von lichtempfindlichen Elementen (5) und der zweiten Glasschicht (9) in einem vorbestimmten Abstand angeordnet ist.

7. Fahrzeug mit einer Fahrzeug-Scheibe nach einem der vorhergehenden Ansprüche.

8. Fahrzeug nach Anspruch 7, **dadurch gekennzeichnet, dass** das Fahrzeug ein Land-, See-, Luft- oder Raumfahrzeug ist.

## Claims

1. Vehicle window with an anisotropic light sensor, having a first glass layer (1) and a second glass layer (9), which are connected to one another by a surrounding layer (3), wherein an arrangement of light-sensitive elements (5) is arranged, substantially parallel to the first glass layer (1), between the first glass layer (1) and the second glass layer (9), wherein the pane furthermore has an aperture (7) such that light can shine through the second glass layer (9) and the aperture (7) onto at least one of the light-sensitive elements (5), wherein depending on the direction of incident light, the sensor provides a signal that is indicative of the direction, wherein the arrangement of light-sensitive elements (5) has a camera chip and wherein the arrangement of light-sensitive elements (5) is arranged on a flexible film (4), wherein an intermediate space (6) is defined by the aperture (7), the arrangement of the light-sensitive elements (5) and the surrounding layer (3),
wherein the intermediate space (6) is arranged between the aperture (7) and the arrangement of light-sensitive elements (5) and the surrounding layer (3), wherein the intermediate space (6) is a hollow space.

2. Vehicle window according to claim 1, **characterized in that** the arrangement of light-sensitive elements (5) comprises an array-like arrangement of at least four light-sensitive elements.

3. Vehicle window according to any one of the preceding claims, **characterized in that** a bonding material selected from the group comprising polyimide, polyurethane, polymethylene methacrylic acid, polycarbonate, polyethylene terephthalate, polyvinyl butyral, FR6, acrylonitrile-butadiene-styrene-copolymer, polyethylene, polypropylene, polyvinyl chloride, polystyrene, polybutylene terephthalate and polyamide is arranged between the first glass layer (1) and the second glass layer (9).

4. Vehicle window according to claim 3, **characterized in that** the film has a thickness of 50 µm to 500 µm.

5. Vehicle window according to any one of the preceding claims, **characterized in that** the aperture (7) is a pinhole aperture.

6. Vehicle window according to any one of the preceding claims, **characterized in that** the aperture (7) is arranged between the arrangement of light-sensitive elements (5) and the second glass layer (9) at a predetermined distance.

7. Vehicle with a vehicle window according to any one of the preceding claims.

8. Vehicle according to claim 7, **characterized in that** the vehicle is a land, water, air, or space vehicle.

## Revendications

1. Vitre de véhicule avec un capteur de lumière anisotrope, comportant une première couche de verre (1) et une deuxième couche de verre (9) qui sont reliées entre elles par une couche périphérique (3), dans lequel un agencement d'éléments photosensibles (5) est disposé, sensiblement parallèlement à la première couche de verre (1), entre la première couche de verre (1) et la deuxième couche de verre (9), la vitre comportant en outre une ouverture (7) de telle sorte que la lumière peut passer à travers la deuxième couche de verre (9) et l'ouverture (7) sur au moins un des éléments photosensibles (5), dans laquelle, en fonction de la direction de la lumière incidente, le capteur fournit un signal qui indique la direction, dans laquelle l'agencement d'éléments photosensibles (5) comporte une puce de caméra et dans laquelle l'agencement d'éléments photosensibles (5) est disposé sur un film flexible (4), dans lequel un espace intermédiaire (6) est défini par l'ouverture (7), l'agencement des éléments photosensibles (5) et la couche environnante (3),
dans lequel l'espace intermédiaire (6) est disposé entre l'ouverture (7) et l'agencement des éléments photosensibles (5) et la couche environnante (3), dans lequel l'espace intermédiaire (6) est un espace creux.

2. Vitre de véhicule selon la revendication 1, **caractérisée en ce que** l'agencement d'éléments photosensibles (5) comprend un agencement en réseau d'au moins quatre éléments photosensibles.

3. Vitre de véhicule selon l'une quelconque des revendications précédentes, **caractérisée en ce qu'**un matériau de liaison choisi parmi le groupe comprenant le polyimide, le polyuréthane, l'acide polyméthacrylique de méthylène, le polycarbonate, le polyéthylène téréphtalate, le polyvinylbutyral, le FR6, le copolymère d'acrylonitrile-butadiène-styrène, le polyéthylène, le polypropylène, le chlorure de polyvinyle, polystyrène, polybutylène téréphtalate et polyamide est disposé entre la première couche de verre (1) et la deuxième couche de verre (9).

4. Vitre de véhicule selon la revendication 3, **caractérisée en ce que** le film a une épaisseur comprise entre 50 µm et 500 µm.

5. Vitre de véhicule selon l'une quelconque des revendications précédentes, **caractérisée en ce que** l'ouverture (7) est une ouverture de type sténopé.

6. Vitre de véhicule selon l'une quelconque des revendications précédentes, **caractérisée en ce que** l'ouverture (7) est disposée entre l'agencement d'éléments photosensibles (5) et la deuxième couche de verre (9) à une distance prédéterminée.

7. Véhicule avec une vitre de véhicule selon l'une quelconque des revendications précédentes.

8. Véhicule selon la revendication 7, **caractérisé en ce que** le véhicule est un véhicule terrestre, aquatique, aérien ou spatial.
